# EUROPÄISCHE PATENTSCHRIFT

(11) **EP 4 267 980 B1**
(45) Veröffentlichungstag und Bekanntmachung des Hinweises auf die Patenterteilung: **10.07.2024**
(21) Anmeldenummer: 21840005.9
(22) Anmeldetag: 17.12.2021
(51) Int. Cl.: G01R 33/032, G01R 33/26

(54) **VERFAHREN UND VORRICHTUNG ZUR BESTIMMUNG EINER MAGNETISCHEN FLUSSDICHTE SOWIE VERFAHREN ZUR HERSTELLUNG EINER SOLCHEN VORRICHTUNG**
METHOD AND APPARATUS FOR DETERMINING A MAGNETIC FLUX DENSITY AND MANUFACTURING METHOD FOR SUCH AN APPARATUS
PROCEDE ET APPAREIL POUR DETERMINER UNE DENSITE DE FLUX MAGNETIQUE ET PROCEDE DE FABRICATION D'UN TEL APPAREIL

(30) Priorität: 23.12.2020 DE 102020134883
(43) Veröffentlichungstag der Anmeldung: 01.11.2023
(73) Patentinhaber: Quantum Technologies GmbH, 04103 Leipzig (DE)
(72) Erfinder: MEIJER, Jan Berend, 04109 Leipzig (DE); HEITMANN, Johannes, 09599 Freiberg (DE)
(74) Vertreter: Hecht, Jan-David
(86) Internationale Anmeldenummer: PCT/EP2021/086563
(87) Internationale Veröffentlichungsnummer: WO 2022/136175

(56) Entgegenhaltungen:
- DE-A1- 102018 202 238
- DE-A1- 102018 216 033
- JP-A- 2014 095 025
- US-A1- 2017 212 182

## Beschreibung

Die vorliegende Erfindung betrifft eine Vorrichtung zur Bestimmung einer magnetischen Flussdichte nach dem Oberbegriff von Anspruch 1 und ein Verfahren zur Bestimmung einer magnetischen Flussdichte mit einer solchen Vorrichtung nach dem Oberbegriff von Anspruch 14 sowie ein Verfahren zur Herstellung einer Vorrichtung zur Bestimmung der magnetischen Flussdichte nach dem Oberbegriff von Anspruch 9.

Die Vermessung magnetischer Flussdichten ist eine Grundfunktion der Sensorik, um daraus magnetische Feldstärken, diese bewirkende Stromflüsse, aber auch andere physikalische Größen zu bestimmen.

Aus der DE 10 2015 208 151 A1 und der DE 10 2017 205 099 A1 sind Verfahren bekannt, bei dem die Fluoreszenzintensität eines Diamantmaterials mit einem Stickstofffehlstellenzentrum ausgewertet wird, um auf das magnetische Feld, welches auf das Stickstofffehlstellenzentrum einwirkt, und den dieses magnetische Feld verursachenden elektrischen Strom eines Leiters rückschließen zu können. Dabei werden zwei unterschiedliche Anregungen, nämlich eine optische und eine Mikrowellenanregung des Stickstofffehlstellenzentrums eingesetzt, was die entsprechende Vorrichtung teuer und komplex macht.

Aus der DE 10 2018 216 033 A1, der DE 10 2018 202 238 A1 und der US 2017/212182 A1 sind weitere Verfahren und Apparaturen bekannt, wo die Anregungsquelle, das Diamantmaterial und/oder das Sensorelement zur Messung der Fluoreszenzintensität in einem integrierten Bauelement vorliegen.

Mit dem Betrag F.M. Stürner et al.: "Compact integrated magnetometer based on nitrogenvacancy centres in diamond", Diamond & Related Material 93 (2019) 59-65 wird zwar schon ein relativ kompakter Sensor angegeben, dieser weist allerdings immer noch eine beträchtliche Größe von ca. 2,9 cm³ auf, wobei diese Größe nicht die erforderliche Mikrowellenanregung berücksichtigt, die extern zur Verfügung gestellt werden muss.

Es ist Aufgabe der vorliegenden Erfindung, die Vermessung der magnetischen Flussdichte im Rahmen einer einfachen und kostengünstigen Sensorik zu ermöglichen, die dennoch eine gute Nutzbarkeit aufweist. Insbesondere soll ein entsprechender Sensor auch sehr klein und mobil verwendbar sein.

Diese Aufgabe wird gelöst mit der erfindungsgemäßen Vorrichtung zur Bestimmung einer magnetischen Flussdichte nach Anspruch 1 und dem erfindungsgemäßen Verfahren zur Bestimmung einer magnetischen Flussdichte mit dieser Vorrichtung nach Anspruch 14 sowie dem erfindungsgemäßen Verfahren zur Herstellung einer Vorrichtung zur Bestimmung der magnetischen Flussdichte nach Anspruch 19. Vorteilhafte Weiterbildungen sind in den Unteransprüchen und in der nachfolgenden Beschreibung zusammen mit den Figuren angegeben.

Im Rahmen der vorliegenden Erfindung wird beim Magnetfeld zwischen magnetischer Feldstärke (magnetische Erregung) und magnetischer Flussdichte unterschieden. Genaugenommen ist die magnetische Flussdichte B abhängig von der magnetischen Erregung H entsprechend dem Zusammenhang B = µ₀ µᵣ H, wobei µ₀ die magnetische Feldkonstante ist und µᵣ die Permeabilitätszahl. Gemessen wird dabei die magnetische Flussdichte, während beim Stromfluss durch einen Leiter, insbesondere eine Spule, ein magnetisches Feld mit einer bestimmten Feldstärke erzeugt wird.

Erfinderseits wurde erkannt, dass diese Aufgabe in überraschender Art und Weise dadurch besonders einfach dadurch gelöst werden kann, dass zur Bestimmung der magnetischen Flussdichte die Abhängigkeit einer Lumineszenz bzw. eines Photostroms von der magnetischen Flussdichte für ein bestimmtes Material verwendet wird, wobei das Material in der Sensorik einstückig integriert ist. Dadurch ist die entsprechende Sensorik besonders kompakt aufgebaut. Wenn die physikalische Anregung durch den einstückigen Aufbau sehr nah an das Material herangebracht wird, besteht dabei eine sehr hohe Ausbeute und damit Nutzbarkeit.

Es gibt zahlreiche Materialien, für die solche Abhängigkeiten einer Lumineszenz bzw. eines Photostroms von der magnetischen Flussdichte vorliegen. Beispielsweise sei auf Diamanten mit Stickstofffehlstellenzentren für die Abhängigkeit der Lumineszenz von der magnetischen Flussdichte verwiesen. Außerdem besteht ein enger Zusammenhang zwischen der Lumineszenz und dem Photostrom ("Der Zusammenhang von Elektronenemission und Lumineszenzerscheinungen angeregter Kristalle", Z. Naturforschg. 10a, 47-52 (1955)).

Die entsprechenden Abhängigkeiten der Lumineszenzintensität bzw. der Photostromintensität sind über weite Bereiche der magnetischen Flussdichte monoton und kontinuierlich fallend mit größer werdenden magnetischen Flussdichten, so dass die magnetische Flussdichte in diesen Bereichen leicht durch eine Messung der jeweiligen Intensität bestimmt werden kann. Beispielsweise entwickelt sich diese Abhängigkeit für das Stickstofffehlstellenzentrum in Diamant im Bereich einer magnetischen Flussdichte von 0 mT bis 51,2 mT (der Lage der NV-P1-Resonanz) monoton und kontinuierlich fallend ("Lumineszenz-Quenching"), so dass mit einer darauf basierenden Sensorik in diesem Bereich magnetische Flussdichten bestimmt werden können. Wenn NV-Zentren in mehreren nicht ausgerichteten Diamant-Nanopartikeln vorliegen, zeigt sich eine monotone und kontinuierlich fallende Abhängigkeit über den Bereich der magnetischen Flussdichte von ca. 5 mT bis ca. 200 mT. Eine ähnliche Abhängigkeit würde sich auch zeigen, wenn anstelle von Nanopartikeln das Diamantmaterial als ausgedehntes Schicht- oder Bulkmaterial vorliegen würde, das bezüglich seiner NV-Zentren ebenfalls nicht ausgerichtet ist, wobei für das Bulkmaterial die Strukturen (GSLAC, NV-P1-Resonanz, etc.) immer noch etwas sichtbar sind.

Die erfindungsgemäße Vorrichtung zur Bestimmung der magnetischen Flussdichte weist ein erstes Material, das bei einer physikalischen Anregung eine Lumineszenz und/oder einen Photostrom erzeugt, wobei die Luminszenz bzw. der Photostrom von der magnetischen Flussdichte abhängig ist, Mittel zur Erzeugung der physikalischen Anregung und Mittel zur Messung der Lumineszenz bzw. des Photostroms mit einem Erfassungssignal, das die Stärke des erfassten Lumineszenzsignals bzw. Photostromsignals wiedergibt, auf und ist dadurch gekennzeichnet, dass das erste Material und die Mittel zur Erzeugung der physikalischen Anregung einstückig ausgebildet sind und/oder das erste Material und die Mittel zur Messung der Lumineszenz bzw. des Photostroms einstückig ausgebildet sind.

"Mittel zur Erzeugung der physikalischen Anregung" sind jegliche Mittel, mit denen die physikalische Anregung erzeugbar ist. Dabei kommt es nicht darauf an, dass die Größe der physikalischen Anregung tatsächlich veränderbar ist. Es reicht, wenn die physikalische Anregung so erzeugbar ist, dass eine Lumineszenz bzw. ein Photostrom in dem ersten Material angeregt wird.

"Einstückig" bedeutet im Rahmen der vorliegenden Erfindung, dass die miteinander einstückig verbundenen Bauteile zwar nicht aus einem einzigen und einheitlichen Teil ("einteilig") gefertigt werden, jedoch nicht nur fest, sondern so innig miteinander verbunden sind, dass sie nicht als mehrere aneinander gefügte Bauteile erscheinen und jedenfalls nicht mehr voneinander gelöst werden können, ohne dabei zerstört zu werden. "Einstückig" bewegt sich somit zwischen den Begriffspolen der bloßen "hinreichend festen Verbindung" und der "Einteiligkeit".

In einer vorteilhaften Weiterbildung ist vorgesehen, dass das erste Material und die Mittel zur Erzeugung der physikalischen Anregung einteilig ausgebildet sind und/oder das erste Material und die Mittel zur Messung der Lumineszenz bzw. des Photostroms einteilig ausgebildet sind. Dadurch ist die Sensorik noch kompakter darstellbar, weil die die entsprechenden Bauteile der Vorrichtung direkt aufeinander ggf. unter Zwischenschaltung anderer Bauelemente aufgebaut werden. Beispielsweise können diese Bauelemente als Schichten bzw. Schichtpakete direkt aufeinander erzeugt werden.

In einer vorteilhaften Weiterbildung ist vorgesehen, dass das erste Material und die Mittel zur Erzeugung der physikalischen Anregung und/oder das erste Material und die Mittel zur Messung der Lumineszenz bzw. des Photostroms als Schichten eines Schichtstapels vorliegen. Dadurch ist die Vorrichtung besonders kompakt aufgebaut. Der Schichtstapel kann dabei mit oder ohne gesondertes Substrat bestehen und in Bezug auf ein solches Substrat verschiedene Reihenfolgen annehmen. Beispielsweise könnte die Reihenfolge Substrat, Mittel zur Erzeugung der physikalischen Anregung, Material, Mittel zur Messung der Lumineszenz bzw. des Photostroms vorliegen. Es könnte sich um die Reihenfolge Substrat, Mittel zur Messung der Lumineszenz bzw. des Photostroms, Material, Mittel zur Erzeugung der physikalischen Anregung handeln. Außerdem könnte es sich um die Reihenfolge Substrat, Mittel zur Messung der Lumineszenz bzw. des Photostroms, Mittel zur Erzeugung der physikalischen Anregung, Material handeln. Weiterhein könnte es sich um die Reihenfolge Substrat, Material, Mittel zur Erzeugung der physikalischen Anregung, Mittel zur Messung der Lumineszenz bzw. des Photostroms handeln. Jeweils könnten noch Schichten dazwischen angeordnet sein.

In einer vorteilhaften Weiterbildung ist vorgesehen, dass zwischen den Mitteln zur E rzeugung der physikalischen Anregung und den Mitteln zur Messung der Lumineszenz bzw. des Photostroms Mittel zur Dämpfung der physikalischen Anregung angeordnet sind, wobei die Mittel zur Dämpfung bevorzugt als dielektrischer Spiegel, insbesondere als Bragg-Spiegel, ausgebildet sind. Dadurch wird die Messgenauigkeit erhöht, weil die Anregung die Messung nicht verfälscht.

In einer vorteilhaften Weiterbildung ist vorgesehen, dass das erste Material eine Kristallstruktur aufweist mit zumindest einer Fehlstelle, wobei das erste Material bevorzugt Diamant, Siliziumkarbid oder Silizium ist und die Fehlstelle ein Farbzentrum, insbesondere ein Stickstofffehlstellenzentrum oder ein Stickstofffehlstellenzentrum in Verbindung mit einem Europiumfehlstellenzentrum, einem Vanadiumfehlstellenzentrum oder einem Manganfehlstellenzentrum ist. Diese Materialien weisen sehr gut bekannte Lumineszenzverläufe auf. An dieser Stelle sei auf A. Zaitsev, "Optical Properties of Diamond", 2001, Springer, Berlin, verwiesen, wo zahlreiche geeignete Farbzentren im Diamant angegeben sind. Der Offenbarungsgehalt dieser Veröffentlichung hinsichtlich Farbzentren im Diamant wird hiermit vollumfänglich einbezogen. Dieses erste Material kann beispielsweise als Diamant vom Typ Ib vorliegen, der von Natur aus Stickstofffehlstellenzentren aufweist, oder es kann als Diamant oder Diamantschicht vorliegen, worin nachträglich Stickstofffehlstellenzentren erzeugt wurden, wie es beispielsweise in der PCT/EP2020/068110 gezeigt ist, deren diesbezüglicher Inhalt hiermit vollumfänglich aufgenommen wird. Vorzugsweise liegt das Diamantmaterial bezüglich seiner NV-Zentren nicht ausgerichtet vor, weil sich dann eine monoton und kontinuierlich fallende Abhängigkeit der Lumineszenz von der magnetischen Flussdichte über den Bereich der magnetischen Flussdichte von ca. 5 mT bis ca. 200 mT ergibt.

Die maximale Steigung und damit die größte Messempfindlichkeit findet man im Bereich von ca. 10 mT bis ca. 15 mT. Man kann daher vorteilhaft eine Kompensationsschaltung einsetzen, um die Lumineszenz immer in diesem Bereich der magnetischen Flussdichte zu bestimmen. Zu diesem Zweck würde man beispielsweise eine Spule von einem elektrischen Strom durchfließen lassen und dabei den Strom so regeln, dass sich eine konstante Lumineszenz einstellt, die beispielsweise einer magnetischen Flussdichte von 12 mT entspricht. Über den eingespeisten Strom kann dann auf die zu messende magnetische Flussdichte geschlossen werden. Es handelt sich also um eine Kompensationsschaltung zur Beibehaltung eines festen Wertes der gemessenen Lumineszenz.

Alternativ oder zusätzlich kann eine magnetische Flussdichte von wenigstens 5 mT, bevorzugt mindestens 7 mT, insbesondere mindestens 10 mT angelegt werden, um das Messergebnis in Anbetracht auf da Maximum der Lumineszenz bei ca. 5 mT eindeutig bestimmbar zu machen. Durch diesen Bias in Bezug auf die magnetische Flussdichte wird verhindert, dass im Anstieg zwischen 0 mT und 5 mT die Lumineszenz gemessen wird.

In einer vorteilhaften Weiterbildung ist daher vorgesehen, dass Mittel zur Erzeugung einer magnetischen Flussdichte bestehen,
wobei die Mittel zur Erzeugung einer magnetischen Flussdichte angepasst sind, eine magnetische Flussdichte von zumindest 5 mT, bevorzugt zumindest 7 mT, insbesondere von zumindest 10 mT zu erzeugen, und/oder
wobei die Mittel zur Erzeugung einer magnetischen Flussdichte angepasst sind, so geregelt zu werden, dass sich eine bestimmte Lumineszenz einstellt.

Die Vorsehung eines Bias bzw. einer Kompensation ist für beliebige erste Materialien möglich. Außerdem können Bias bzw. Kompensation nicht nur bei einer Lumineszenzmessung, sondern auch bei einer Photostrommessung vorteilhaft eingesetzt werden.

In einer vorteilhaften Weiterbildung ist vorgesehen, dass die Mittel zur Erzeugung der physikalischen Anregung eine elektrische oder elektromagnetische Anregung, bevorzugt eine Anregung im optischen Bereich, insbesondere eine LASER-Anregung oder eine LED-Anregung, oder eine Anregung durch ionisierende Strahlung, bereitstellen. Dadurch lässt sich eine Lumineszenz bzw. ein Photostrom sehr einfach anregen, wobei die Mittel sehr kompakt gehalten werden können. Bei den LED kann es sich um Halbleiter-LED handeln, muss aber nicht. Vorzugsweise wird keine Mikrowellenanregung vorgenommen, weil dann die Vorrichtung sehr kompakt gehalten werden kann.

Wenn anstelle einer elektromagnetischen Anregung eine elektrische Anregung (beispielsweise mit elektrischen Kontakten) verwendet wird, dann können beispielsweise LEDs für eine optische Anregung entfallen, was entsprechende Sensorik wesentlich kompakter gestaltet. Außerdem bestünde die Möglichkeit, die Ortsauflösung eines entsprechenden Sensors stark zu erhöhen. Genauer gesagt könnte man die Anregung auf einem deutlich kleineren Bereich durch elektrische Kontakte beschränken und würde im Gegensatz zur optischen Detektion nicht Signale aus dem ganzen Material erhalten. Bislang war eine elektrische Anregung daran gescheitert, dass das NV-Zentrum in Diamant ionisiert wurde, allerdings kann dies durch das Anheben des Fermi-Levels, beispielsweise durch eine Phosphor-Dotierung im Diamant, verhindert werden.

In einer vorteilhaften Weiterbildung ist vorgesehen, dass transparente elektrische Kontakte auf dem ersten Material vorliegen. Beispielsweise könnten sogenannte transparente leitfähige Kontakte (TCO - "transparent conducting oxides"), wie Indiumzinnoxid ("ITO"), Fluorzinnoxid, Aluminiumzinkoxid oder Antimonzinnoxid, verwendet werden. Diese Kontakte können sowohl im Rahmen der Auslesung des Photostroms als auch für eine elektrische Anregung verwendet werden.

Beispielhafte Methoden der elektrischen Anregungen von Farbzenten in Diamant sind z.B. aus der DE 43 22 830 A1 und aus B. Burchard "Elektronische und optoelektronische Bauelemente und Bauelemente Grundstrukturen auf Diamantbasis", Dissertation, Hagen, 1994 bekannt. Insbesondere kann die Anregung der Lumineszenz durch PIP- oder PIN-Dioden erfolgen. Hierzu sei auch auf B. Tegetmeyer et Al. "Charge state modulation of nitrogen vacancy centers in diamond by applying a forward voltage across a p-i-n junction", Diamond and Related Materials, Volume 65, May 2016, Pages 42-46 und B. Tegetmeyer et Al. "Electroluminescence from silicon vacancy centers in diamond p-i-n diodes" Diamond and Related Materials Volume 65, May 2016, Pages 42-46 beispielhaft verwiesen. Eine Anregung über PN-Dioden ist auch denkbar. Bei der beispielhaften Verwendung von Diamant und einer PIP-Diode injiziert bei Anlegen einer ausreichend hohen Spannung an die PIP-Diode, ein erstes dotiertes Gebiet, beispielsweise ein p+-dotiertes Gebiet, Ladungsträger - hier Löcher -in den intrinsischen Bereich. Dort werden diese durch das elektrische Feld der angelegten Spannung beschleunigt und regen die Farbzentren durch Stöße an, woraufhin diese zu leuchten beginnen. Effizienter ist die Anregung über die Injektion von Elektronen und Löchern, beispielsweise in PIN-Dioden. Durch Bandgap-Engineering oder die Verwendung anderer-Materialien können auch direkte Übergänge erzeugt werden, wobei dann aber andere Farbzentren benutzt werden müssen, da Farbzentren immer materialspezifisch bestehen. Es ist denkbar LEDs, wie die zuvor beschriebenen, nur kapazitiv oder mittels Übertrager oder anders galvanisch getrennt an eine Wechselsignalquelle anzukoppeln. Dies ist insbesondere bei der CMOS-Integration von Vorteil.

In einer vorteilhaften Weiterbildung ist vorgesehen, dass die Mittel zur Erzeugung der physikalischen Anregung eine Quelle und Konversionsmittel aufweisen, wobei die Quelle eine erste physikalische Anregung erzeugt und die Konversionsmittel die erste physikalische Anregung in eine zweite physikalische Anregung umwandeln. Dann können Quellen mit einer hohen Intensität verwendet werden, um so die Messgenauigkeit zu erhöhen. Beispielsweise könnte eine Anregung im blauen Lichtspektrum erfolgen, wobei das Konversionsmittel diese Anregung absorbiert und seinerseits Licht im grünen Lichtspektrum emittiert, die dann in dem Material die Lumineszenz anregt.

In einer vorteilhaften Weiterbildung ist vorgesehen, dass die Mittel zur Erzeugung der physikalischen Anregung ein zweites Material aus der Gruppe: AIN, AlGaN, AIGalnN, C, BN, GaN, GaP, GaAsP, AlGaInP, AlGaP, InGaN, ZnO; ZnSe, SiC und Si umfassen. LED-Strukturen mit diesen Materialien sind geeignet, Licht im ultravioletten (AIN, AlGaN, AIGalnN, C, BN), violetten (InGaN) blauen (ZnSe, InGaN, SiC, Si, ZnO), grünen (InGaN, GaN, GaP, AIGalnP, AlGaP, ZnO) bzw. gelben (GaAsP, AlGaInP, GaP) Lichtspektrum mit hoher Intensität zu emittieren.

In einer vorteilhaften Weiterbildung ist vorgesehen, dass die Konversionsmittel ein drittes Material aus der Gruppe: Phosphormaterial, metallische Nanocluster, seltene Erden, CdS, CdSe, CdTe, GaAs und InP umfassen. Hierzu wird auf die beiden Veröffentlichungen C.C. Lin und R.-S. Liu: "Advances in Phosphors for Light-emitting Diodes", J. Phys. Chem. Lett. 2011, 2, 1268-1277 und A.K. Lunia et al.: "Theoretical analysis of blue to white down conversion for light-emitting diodes with yttrium aluminium garnet phosphor", Journal of Photonics for Energy, Vol. 4, 2014, 043596-1 - 043596-10 verwiesen, deren diesbezüglicher Inhalt vollumfänglich aufgenommen wird. Aus diesen Veröffentlichungen geht hervor, dass für eine Konversion von blauem Licht in grünes Licht ein grünes Phosphormaterial, beispielsweise mit der Zusammensetzung SrAl₂O₄/Eu verwendet werden kann. Außerdem geht daraus hervor, dass auch Halbleiter-Nanokristalle und Quantenpunkte für eine solche Konversion nutzbar sind, wobei durch die Einstellung der Größe dieser Elemente eine Anpassung der gewünschten Emission erfolgen kann, wobei vorteilhaft eine breite Absorptionsbande aber nur eine schmale Emissionsbande bestehen. Außerdem ist die Quantenausbeute hoch und die Lichtstreuung gering.

Die Materialien CdS, CdSe, CdTe, GaAs und InP können beispielsweise für die Herstellung solcher Quantenpunkte verwendet werden. Nanokristalle können zusammen mit seltenen Erden in ein entsprechendes Phosphormaterial eingebettet werden.

Metallische Nanocluster können zur Erzeugung von Oberflächenplasmonen (plasmo nisches Nahfeld) verwendet werden, die wiederum die Konversion bewirken. Beispielsweise kann das plasmonischen Nahfeld zur Anregung von NV-Zentren genutzt werden. In S. Seidel, J. Heitmann et al. Thin Solid Films. 606,13-18 (2016) konnte die Einbettung von Au-Nanoclustern in SolGel-ZrO₂ mit hoher thermischer Stabilität gezeigt werden. Die Au-Nanocluster zeigen eine Surface-Plasmon-Resonance (SPR) im Bereich 540-590 nm, die über die Größe der Cluster und die Kristallinität des Matrixmaterials einstellbar ist. Diese Wellenlänge entspricht der optimalen Anregungsenergie der NV-Zentren. Die Anregung ist durch das Nahfeld des SPRs effizienter als eine rein strahlende Anregung.

In einer vorteilhaften Weiterbildung ist vorgesehen, dass zumindest Teile der Mittel zur Erzeugung, bevorzugt die Konversionsmittel, in einer Matrix mit dem ersten Material, insbesondere im Rahmen einer gemeinsamen Schicht, vorliegen. Die Einbindung der Konversionsmittel in die Matrixschicht kann beispielsweise über ein SolGel-Verfahren, ein SOG-Verfahren (Spin on Glas-Verfahren) oder durch Inkjet-Printing erfolgen. Dann ist die physikalische Anregung besonders effektiv. Außerdem können strahlungslose Anregungen, beispielsweise durch den Förster-Transfer erfolgen, was die Effizienz der Anregung noch einmal deutlich erhöht. Vor allem dann, wenn das Material homogen verteilt in der Matrix vorliegt, lässt sich ein Förster-Transfer hervorrufen. In L. Liebermeister et al.: "Tapered fiber coupling of single photons emitted be deterministic positioned single nitrogen vacancy center", Appl. Phys. Lett. 104, 031101 (2014) wurde schon grundsätzlich die Möglichkeit gezeigt, einen Förster-Transfer zur Anregung von NV-Zentren zu verwenden. Für die Anregung eines solchen Förster-Transfers ist auch eine möglichst große Nähe des ersten Materials und des Konversionsmaterials hilfreich, da die Anregungseffizienz proportional zur 6. Potenz des Abstandes sinkt.

Alternativ können die Konversionsmittel und das erste Material auch getrennt voneinander, insbesondere in verschiedenen Schichten vorliegen. Dabei wird aber eine direkt benachbarte Anordnung der beiden Schichten bevorzugt.

In einer vorteilhaften Weiterbildung ist vorgesehen, dass das erste Material Körner aufweist, die vorzugsweise eine Korngröße im Bereich 100 nm bis 10 µm, bevorzugt im Bereich 200 nm bis 3 µm, insbesondere im Bereich 500 nm bis 1 µm aufweisen. Dann lässt sich das erste Material besonders leicht herstellen und auch eine Matrix mit den Konversionsmitteln ließe sich einfach herstellen.

Alternativ könnte das erste Material aber auch als geschlossene Schicht erzeugt werden. Beispielsweise könnte eine Diamantschicht abgeschieden und anschließend darin Stickstofffehlstellenzentren erzeugt werden.

In einer vorteilhaften Weiterbildung ist vorgesehen, dass Mittel zur Messung der Lumineszenz einen Photodetektor umfassen. Dadurch wird die Sensorik besonders einfach und kostengünstig darstellbar. Der Empfindlichkeitsbereich des Photodetektors ist auf das Spektrum der Lumineszenz abzustellen. Ein solcher Photodetektor könnte beispielsweise ein Halbleiterphotodetektor beispielsweise auf a-Si-Basis oder eine c-Si pn-Diode sein, wenn Licht im roten Spektralbereich detektiert werden soll, wie es bei Stickstofffehlstellenzentren in Diamant der Fall ist.

In einer besonders bevorzugten Weiterbildung besteht eine auf GaN als zweitem Material basierende LED-Struktur, auf der eine Matrixschicht besteht, die Diamantkörner mit Stickstofffehlstellenzentren als erstes Material und einem Konversionsmittel in Form von Partikeln aus grünem Phosphormaterial als drittes Material aufweist, wobei die Diamantkörner und die Partikel aus grünem Phosphormaterial beispielsweise in einer Siliziumbasierten Prekursor-Lösung gemischt und gemeinsam im Rahmen eines Sol-Gel-Verfahrens abgeschieden wurden. Dann ist die Vorrichtung besonders effizient und kompakt. Dabei kann die Anregung der Stickstofffehlstellenzentren auch strahlungslos über einen Förster-Transfer erfolgen.

Unabhängiger Schutz wird beansprucht für das erfindungsgemäße Verfahren zur Herstellung einer Vorrichtung zur Bestimmung der magnetischen Flussdichte, wobei die Vorrichtung ein erstes Material, das bei einer physikalischen Anregung eine Lumineszenz und/oder einen Photostrom erzeugt, wobei die Lumineszenz bzw. der Photostrom von der magnetischen Flussdichte abhängig ist, Mittel zur Erzeugung der physikalischen Anregung und Mittel zur Messung der Lumineszenz bzw. des Photostroms mit einem Erfassungssignal, das die Stärke des erfassten Lumineszenzsignals bzw. Photostromsignals wiedergibt, aufweist, dadurch gekennzeichnet, dass das erste Material und die Mittel zur Erzeugung der physikalischen Anregung einstückig ausgebildet werden und/oder das erste Material und die Mittel zur Messung der Lumineszenz bzw. des Photostroms einstückig ausgebildet werden.

In einer vorteilhaften Weiterbildung ist vorgesehen, dass die erfindungsgemäße Vorrichtung hergestellt wird.

In einer vorteilhaften Weiterbildung ist vorgesehen, dass eine LED-Struktur erzeugt und darauf das erste Material angeordnet, bevorzugt abgeschieden wird, wobei das erste Material insbesondere in einer Matrix mit den Konversionsmitteln angeordnet wird.

In einer vorteilhaften Weiterbildung ist vorgesehen, dass das erste Material und ggf. die Konversionsmittel im Sol-Gel-Verfahren abgeschieden werden.

In einer vorteilhaften Weiterbildung ist vorgesehen, dass die Mittel zur Dämpfung gegenüberliegend von der LED-Struktur auf dem ersten Material und darauf die Mittel zur Messung der Lumineszenz bzw. des Photostroms angeordnet werden, wobei die LED-Struktur, das erste Material, die Mittel zur Dämpfung und die Mittel zur Messung der Lumineszenz bzw. des Photostroms bevorzugt direkt aufeinander angeordnet werden. Dadurch ist die Sensorik sehr kompakt darstellbar, insbesondere in Form eines einzigen Chips.

In einer alternativen vorteilhaften Weiterbildung ist vorgesehen, dass die Mittel zur Dämpfung gegenüberliegend von dem ersten Material auf der LED-Struktur und darauf die Mittel zur Messung der Lumineszenz bzw. des Photostroms angeordnet werden, wobei die Mittel zur Messung der Lumineszenz bzw. des Photostroms, die Mittel zur Dämpfung, die LED-Struktur und das erste Material bevorzugt direkt aufeinander angeordnet werden. Dadurch ist die Sensorik sehr kompakt darstellbar, insbesondere in Form eines einzigen Chips.

Weiterhin wird unabhängiger Schutz beansprucht für das erfindungsgemäße Verfahren zur Bestimmung einer magnetischen Flussdichte mit der erfindungsgemäße Vorrichtung, das dadurch gekennzeichnet ist, dass aus dem Wert der gemessenen Intensität der Lumineszenz bzw. des Photostroms gegenüber einem normierten Verlauf der Intensität der Lumineszenz bzw. des Photostroms in Bezug auf die magnetische Flussdichte die Größe der aktuellen magnetischen Flussdichte bestimmt wird, wobei bevorzugt keine Mikrowellenanregung erfolgt.

In einer vorteilhaften Weiterbildung ist daher vorgesehen, dass Mittel zur Erzeugung einer magnetischen Flussdichte verwendet werden, wobei die Mittel zur Erzeugung einer magnetischen Flussdichte eine magnetische Flussdichte von zumindest 5 mT, bevorzugt zumindest 7 mT, insbesondere von zumindest 10 mT zu erzeugen, und/oder wobei die Mittel zur Erzeugung einer magnetischen Flussdichte so geregelt werden, dass sich eine bestimmte Lumineszenz einstellt.

Die Merkmale und weitere Vorteile der vorliegenden Erfindung werden im Folgenden anhand der Beschreibung bevorzugter Ausführungsbeispiele im Zusammenhang mit den Figuren deutlich werden. Dabei zeigen rein schematisch:
- Fig. 1: die Abhängigkeit der Intensität der Photolumineszenz von NV-Zentren in nicht ausgerichteten Diamant-Nanopartikeln von dem Betrag der magnetischen Flussdichte,
- Fig. 2: eine erste bevorzugte Ausgestaltung der erfindungsgemäßen Vorrichtung,
- Fig. 3: eine zweite bevorzugte Ausgestaltung der erfindungsgemäßen Vorrichtung,
- Fig. 4: eine dritte bevorzugte Ausgestaltung der erfindungsgemäßen Vorrichtung,
- Fig. 5: eine vierte bevorzugte Ausgestaltung der erfindungsgemäßen Vorrichtung,
- Fig. 6: eine fünfte bevorzugte Ausgestaltung der erfindungsgemäßen Vorrichtung,
- Fig. 7: eine sechste bevorzugte Ausgestaltung der erfindungsgemäßen Vorrichtung,
- Fig. 8: eine siebente bevorzugte Ausgestaltung der erfindungsgemäßen Vorrichtung und
- Fig. 9: eine achte bevorzugte Ausgestaltung der erfindungsgemäßen Vorrichtung.

Im Folgenden werden identische Bezugszeichen für identische Elemente verwendet.

Farbzentren sind Gitterfehler in Kristallen, die elektromagnetische Strahlung (beispielsweise im UV-, sichtbaren und/oder IR-Bereich) absorbieren. Dadurch entstehen Banden mit einer bestimmten Wellenlänge.

Sehr gut untersucht ist das sogenannte Stickstoff-Fehlstellen-Zentrum (NV - *nitrogen vacancy,* " NV-Zentrum") im Diamant, einer von über 100 bekannten Defekten im Diamant, das dadurch entsteht, dass ein Kohlenstoffatom im Diamantgitter durch ein Stickstoffatom substituiert wird und dessen Nachbaratom fehlt. Bekannt ist der Diamant vom Typ Ib, bei dem diese NV-Zentren über die gesamte Diamantstruktur gleichmäßig verteilt vorliegen.

Die Fotolumineszenz dieses NV-Zentrums ist stark von dem magnetischen Fluss eines magnetischen Feldes abhängig, dass auf das NV-Zentrum einwirkt.

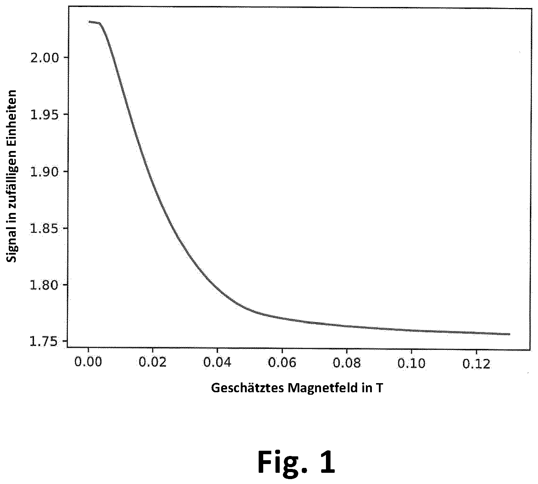

Fig. 1 zeigt die Intensität der Photolumineszenz von NV-Zentren, die in nicht ausgerichteten Diamant-Nanopartikeln vorliegen, in Abhängigkeit von dem Betrag der magnetischen Flussdichte. Es ist zu erkennen, dass sich in diesem Fall eine weitgehend strukturfreie Abhängigkeit zeigt. Eine ähnliche Abhängigkeit würde sich auch zeigen, wenn anstelle von Nanopartikeln das Diamantmaterial als ausgedehntes Schicht- oder als Bulkmaterial vorliegen würde, das bezüglich seiner NV-Zentren ebenfalls nicht ausgerichtet ist.

Die Lumineszenz negativ geladener NV-Zentren findet in einem Wellenlängenbereich von 600- 800 nm statt mit einer Null-Phononen-Linie bei 638 nm. Angeregt werden kann das NV- Zentrum mit Wellenlängen kleiner-gleich 638 nm. Mittels eingeprägter mechanischer Spannungen im Kristall (beispielsweise durch Kavitäten oder einen hohen Druck) ist es möglich, die notwendigen Anregungsenergien zu verschieben, sowie die Lumineszenz-Charakteristik zu verändern.

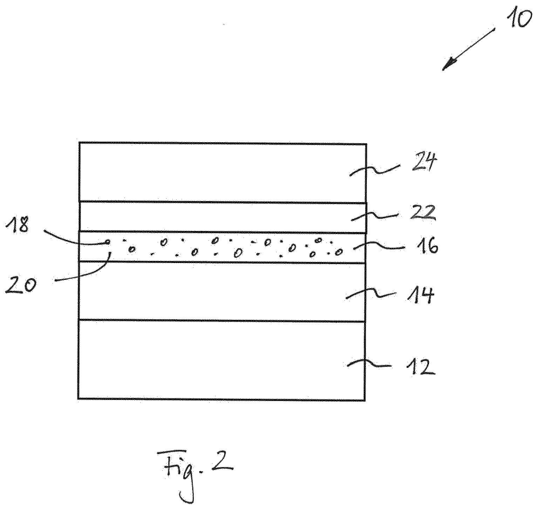

In Fig. 2 ist eine erste bevorzugte Ausgestaltung der erfindungsgemäßen Vorrichtung 10 in einer schematischen Schnittansicht gezeigt.

Es ist zu erkennen, dass diese Vorrichtung 10 ein Substrat 12, beispielsweise aus Silizium, aufweist, auf dem in bekannter Art und Weise eine auf GaN basierende LED-Struktur 14 (beispielsweise in einem GaN/SiC/AIN/ZnO-Schichtaufbau) mittels CVD-Abscheidung erzeugt wurde. Diese LED-Struktur 14 weist elektrische Anschlüsse auf (nicht gezeigt), die vorzugsweise als TCO ausgebildet und in üblicher Art und Weise mit Anschlussverbindungen verbunden sind, die von außen gespeist werden können. Die LED-Struktur 14 ist vorzugsweise auf ein Emissionsmaximum bei 200 nm bis 500 nm eingestellt.

Direkt auf der LED-Struktur 14 wurde eine Matrix-Schicht 16 angeordnet, die sowohl Diamantkörner 18 als auch Konversionsmittel 20 enthält. Hierzu wurden die Diamantkörner 18 als auch die Konversionsmittel 20 im Rahmen eines Sol-Gel-Verfahrens in einer Prekursor-Lösung eingerührt und daraus eine Suspension gebildet, die dann auf der LED-Struktur abgeschieden und in üblicher Weise ausgehärtet wurde.

Die Diamantkörner 18 sind Körner mit einer Korngröße im Bereich 500 nm bis 1 µm und bestehen aus Diamant vom Typ Ib. Sie weisen also Stickstofffehlstellenzentren auf, die unterhalb einer Wellenlänge von 638 nm angeregt werden können.

Als Konversionsmittel 20 kommen Phosphormaterialien, beispielsweise SrAl₂O₄/Eu zum Einsatz.

Die durch die auf GaN basierende LED-Struktur 14 emittierte sehr intensive Strahlung bei 200 nm bis 500 nm wird durch die Konversionsmittel 20 in einen Wellenlängenbereich von 500 nm bis 600 nm konvertiert, wo die Anregung der Stickstofffehlstellenzentren sehr effizient erfolgt. Dadurch kann die sehr hohe Leuchtkraft der LED-Struktur 14 auf jeden Fall optimal zur strahlenden Anregung der Stickstofffehlstellenzentren wirken.

Wenn die Diamantkörner 18 in der Matrix-Schicht 16 sehr homogen verteilt sind und die Konversionsmittel 20 sehr eng an den Diamantkörnern angelagert sind, dann kann sich auch ein strahlungsloser Förster-Transfer einstellen, womit die Anregung der Stickstofffehlstellenzentren noch effizienter erfolgt.

Auf der Matrix-Schicht 16 wurde direkt ein dielektrischer Filter in Form eines Bragg-Spiegels 22 mittels CVD abgeschieden, der beispielsweise eine Vielzahl von aufeinander alternierend angeordneter SiO₂- und SiN-Schichten mit bestimmter Schichtdicke aufweist. Dieser Bragg-Spiegel filtert sowohl die Lichtemissionen der LED-Struktur, als auch der Konversionsmittel, so dass nur die Lichtemissionen der Stickstofffehlstellenzentren im Bereich 600 nm bis 750 nm transmittiert werden.

Auf dem Bragg-Spiegel 22 wurde schließlich eine Photodioden-Struktur 24 mit entsprechenden elektrischen Anschlüssen mittels CVD abgeschieden. Auch hier können die elektrischen Anschlüsse wieder vorzugsweise als TCO ausgebildet und in üblicher Art und Weise mit Anschlussverbindungen verbunden sein, die von außen kontaktiert werden können.

Die beschriebene Vorrichtung 10 liegt als einteiliges Bauelement vor und kann sehr klein als Mikrosensor gefertigt werden. Eine zusätzliche Anregung mit Mikrowellenstrahlung ist nicht erforderlich.

Diese Vorrichtung 10 würde nun anhand bekannter magnetischer Flussdichten hinsichtlich des Messsignals der Photodioden-Struktur 24 geeicht werden. Dann können beliebige magnetische Flussdichten im Bereich ca. 5 mT bis ca. 200 mT einfach über eine Auswertung des Messsignals der Photodiodenstruktur 24 bestimmt werden, da die Abhängigkeit der Lumineszenzintensität der Stickstofffehlstellenzentren über diesen Bereich der magnetischen Flussdichte monoton ist und kontinuierlich fällt ("Lumineszenz-Quenching").

Gegebenenfalls würde man einen Bias für die magnetische Flussdichte von mindestens 5 mT einsetzen und/oder man würde eine Kompensationsschaltung verwenden, wodurch die zumessende magnetische Flussdichte dadurch bestimmt wird, dass die gemessene Lumineszenz bei einem Wert konstant gehalten wird, der einer magnetischen Flussdichte von beispielsweise 12 mT entspricht. Die zu messende magnetische Flussdichte kann dann direkt aus dem zur Erzeugung der zur Kompensation notwendigen magnetischen Flussdichte notwendigen Strom, der durch eine entsprechende Spule fließt, bestimmt werden.

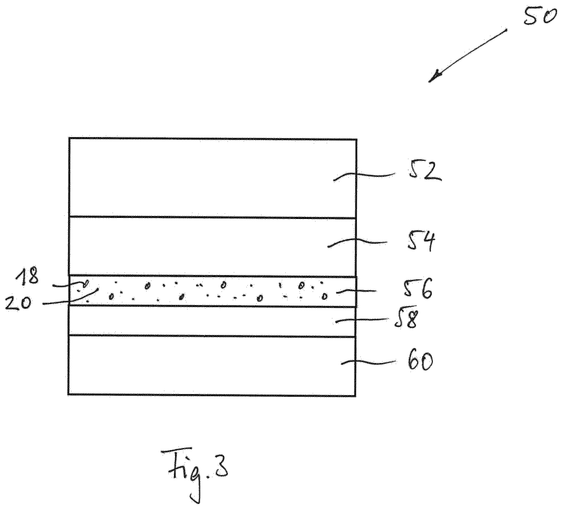

In Fig. 3 ist eine zweite bevorzugte Ausgestaltung der erfindungsgemäßen Vorrichtung 50 rein schematisch im Schnitt gezeigt.

Es ist zu erkennen, dass sich diese Vorrichtung 50 von der Vorrichtung 10 aus Fig. 2 nur dadurch unterscheidet, dass die Schichtreihenfolge auf dem Substrat 52 umgedreht wurde. So wurde hier auf dem Substrat 52 direkt die Photodioden-Struktur 54, darauf die Matrix-Schicht 56 mit den Diamantkörnern 18 und dem Phosphormaterial 20, darauf der Bragg-Spiegel 58 und darauf die LED-Struktur 60 abgeschieden.

Die prinzipielle Wirkungsweise ist dieselbe wie bei der Vorrichtung 10, so dass dies nicht noch einmal wiederholt zu werden braucht.

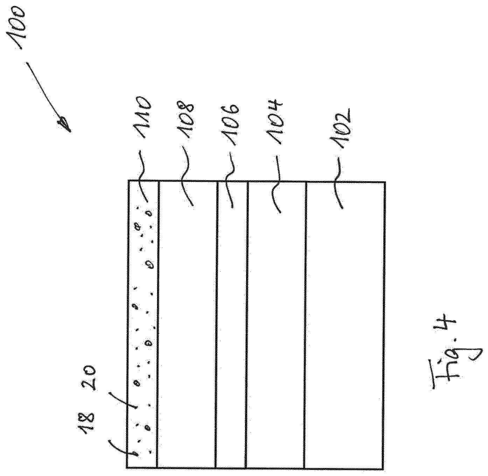

In Fig. 4 ist eine dritte bevorzugte Ausgestaltung der erfindungsgemäßen Vorrichtung 100 rein schematisch im Schnitt gezeigt.

Es ist zu erkennen, dass sich diese Vorrichtung 100 von der Vorrichtung 10 aus Fig. 2 dadurch unterscheidet, dass auf dem Substrat 102 direkt die Photodioden-Struktur 104, darauf der Bragg-Spiegel 106, darauf die LED-Struktur 108 und darauf schließlich die Matrix-Schicht 110 mit den Diamantkörnern 18 und dem Phosphormaterial 20 abgeschieden wurde.

Dabei macht man sich zunutze, dass die LED-Struktur 108 für die Lumineszenz der Stickstofffehlstellenzentren in den Diamantkörnern 18 durchsichtig ist. Ansonsten ist die prinzipielle Wirkungsweise dieselbe wie bei der Vorrichtung 10, so dass dies nicht noch einmal wiederholt zu werden braucht.

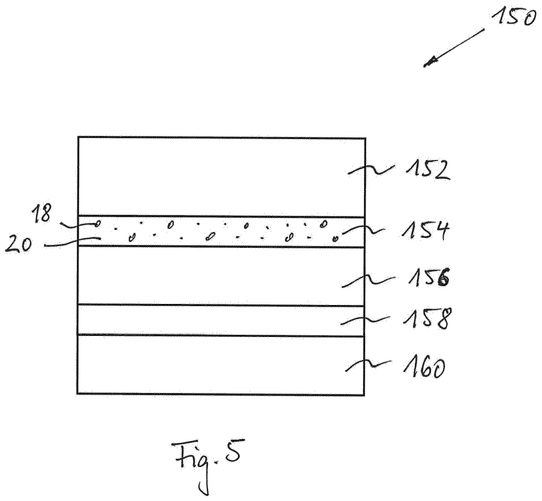

In Fig. 5 ist eine vierte bevorzugte Ausgestaltung der erfindungsgemäßen Vorrichtung 150 rein schematisch im Schnitt gezeigt.

Es ist zu erkennen, dass sich diese Vorrichtung 150 von der Vorrichtung 100 aus Fig. 4 nur dadurch unterscheidet, dass die Schichtreihenfolge auf dem Substrat 152 umgedreht wurde. So wurde hier auf dem Substrat 152 direkt die Matrix-Schicht 154 mit den Diamantkörnern 18 und dem Phosphormaterial 20, darauf die LED-Struktur 156, darauf der Bragg-Spiegel 158 und darauf die Photodioden-Struktur 160 abgeschieden.

Die prinzipielle Wirkungsweise ist dieselbe wie bei der Vorrichtung 100, so dass dies nicht noch einmal wiederholt zu werden braucht.

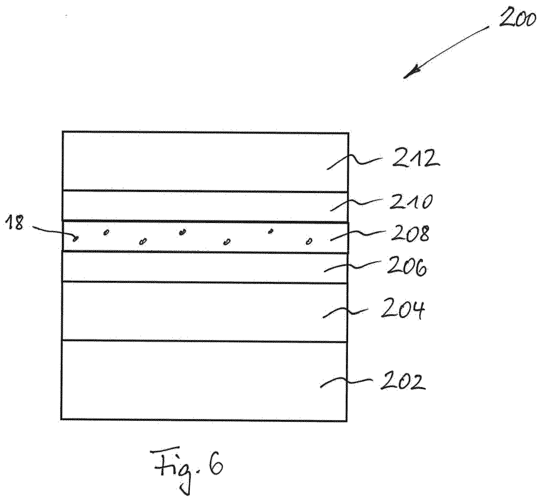

In Fig. 6 ist eine fünfte bevorzugte Ausgestaltung der erfindungsgemäßen Vorrichtung 200 rein schematisch im Schnitt gezeigt.

Es ist zu erkennen, dass sich diese Vorrichtung 200 von der Vorrichtung 10 aus Fig. 2 dadurch unterscheidet, dass keine einheitliche Matrix-Schicht 16 vorliegt, sondern zwei getrennte Schichten 206, 208.

Genauer gesagt besteht bei dieser Vorrichtung wieder direkt auf dem Substrat 202 eine LED-Struktur 204, darauf eine Schicht 206 mit grünem Phosphormaterial, die durch CVD abgeschieden wurde, darauf eine Schicht 208 mit Diamantkörnern 18, die wiederum im Sol - Gel-Verfahren abgeschieden wurde, darauf der Bragg-Spiegel 210 und darauf die Photodioden-Struktur 212.

Bei dieser Vorrichtung 200 findet auch eine Wellenlängenkonversion statt, allerdings wird hier durch die räumliche Entfernung von Diamantkörnern 18 und Phosphormaterial 206 kein Förster-Transfer zu erwarten sein, so dass die Anregung der Stickstofffehlstellenzentren in den Diamantkörnern 18 überwiegend strahlend erfolgen wird.

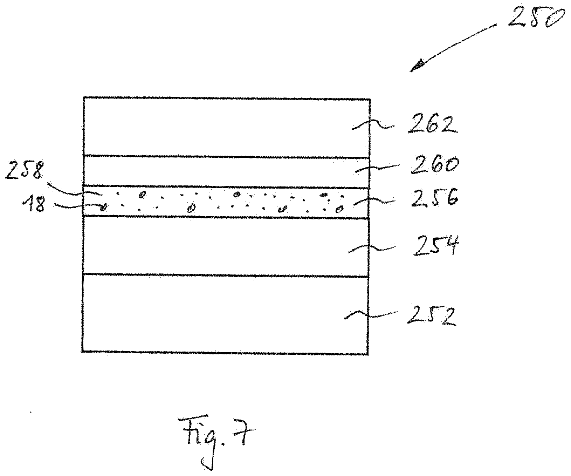

In Fig. 7 ist eine sechste bevorzugte Ausgestaltung der erfindungsgemäßen Vorrichtung 250 rein schematisch im Schnitt gezeigt.

Es ist zu erkennen, dass sich diese Vorrichtung 250 von der Vorrichtung 10 aus Fig. 2 nur dadurch unterscheidet, dass keine Partikel 20 aus grünem Phosphormaterial vorliegen, sondern in der einheitlichen Matrix-Schicht 256 neben den Diamantkörnern 18 Halbleiter-Nanokristalle 258, beispielsweise aus CdS, CdSe, CdTe, GaAs und/oder InP vorliegen, die eine Größe im Bereich 5 nm bis 50 nm aufweisen. Alternativ könnten auch metallische Nanocluster beispielsweise aus Au oder Ag verwendet werden, um eine Konversion mittels Oberflächenplasmonen zu bewirken. Die Größe dieser Nanocluster könnte im Bereich 3 nm bis 50 nm liegen.

Durch diese Nanokristalle findet ebenfalls eine effiziente Wellenlängenkonversion statt, wobei die genaue Lage der Anregung der Stickstofffehlstellenzentren durch die Größe der Nanokristalle angepasst werden kann. Damit kann die Anregung der Stickstofffehlstellenzentren noch effizienter erfolgen, wodurch die Lumineszenzintensität und damit die Messgenauigkeit erhöht werden können.

Ansonsten bleibt der grundsätzliche Aufbau erhalten, wobei direkt auf dem Substrat 252 die LED-Struktur 254, darauf die Matrix-Schicht 256, darauf der Bragg-Spiegel 260 und darauf die Photodioden-Struktur 262 angeordnet sind.

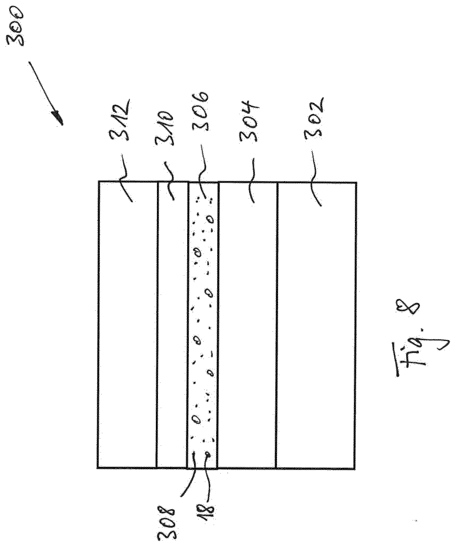

In Fig. 8 ist eine siebente bevorzugte Ausgestaltung der erfindungsgemäßen Vorrichtung 300 rein schematisch im Schnitt gezeigt.

Es ist zu erkennen, dass sich diese Vorrichtung 250 von der Vorrichtung 10 aus Fig. 2 nur dadurch unterscheidet, dass keine Partikel 20 aus grünem Phosphormaterial vorliegen, sondern in der einheitlichen Matrix-Schicht 306 neben den Diamantkörnern 18 Quantenpunkte 308, beispielsweise aus CdS, CdSe, CdTe, GaAs und/oder InP vorliegen. Diese Quantenpunkte wurden hergestellt durch nasschemische Verfahren, wie beispielsweise die Hot-Injection-Methode. Wenn statt solcher Quantenpunkte metallische Nanocluster verwendet werden sollen, könnten die metallischen Nanopartikel (z.B. Au oder Ag) aus dem Salz (im Fall von Au einem Goldsalz) reduziert werden und anschließend in einer organischen Phase angereichert und später daraus herausgelöst werden (vgl. z.B. Nadejda Krasteva et al., "Gold nanoparticle/PPI-dendrimer based chemiresistors: Vapor-sensing properties as a function of the dendrimer size", Sensors and Actuators B: Chemical 92 (1-2) Pages 137-143 (2003)). Anschließend können die Goldpartikel mittels Sol-Gel-Abscheidung in eine dielektrische Matrix eingebettet werden (vgl. z.B. S. Seidel, J. Heitmann et al., "Temperature stable Au nanoparticles embedded in Er3+ doped ZrO2 sol-gel thin films prepared by spin coating.", Thin Solid Films, 606, 13-18 (2016), DOI: 10.1016/j.tsf.2016.03.028), wobei ihr plasmonischer Response vollständig erhalten bleibt.

Durch diese Quantenpunkte findet ebenfalls eine effiziente Wellenlängenkonversion statt, wobei die genaue Lage der Anregung der Stickstofffehlstellenzentren durch die Größe der Quantenpunkte angepasst werden kann. Damit kann die Anregung der Stickstofffehlstellenzentren noch effizienter erfolgen, wodurch die Lumineszenzintensität und damit die Messgenauigkeit erhöht werden können.

Ansonsten bleibt auch hier der grundsätzliche Aufbau erhalten, wobei direkt auf dem Substrat 302 die LED-Struktur 304, darauf die Matrix-Schicht 306, darauf der Bragg-Spiegel 310 und darauf die Photodioden-Struktur 312 angeordnet sind.

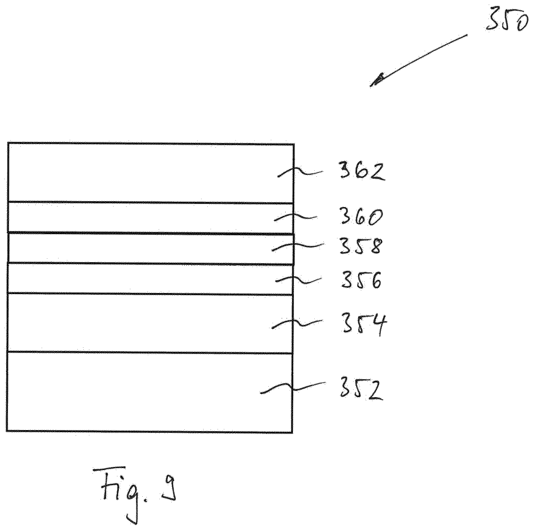

In Fig. 9 ist eine achte bevorzugte Ausgestaltung der erfindungsgemäßen Vorrichtung 350 rein schematisch im Schnitt gezeigt.

Es ist zu erkennen, dass wie bei der Vorrichtung 200 aus Fig. 6 keine einheitliche Matrix-Schicht vorliegt, sondern zwei getrennte Schichten 356, 358. Dabei ist direkt auf dem Substrat 352 eine LED-Struktur 354, darauf eine Schicht 356 mit grünem Phosphormaterial, die durch CVD abgeschieden wurde, darauf eine reine Diamantschicht 358, darauf der Bragg-Spiegel 360 und darauf die Photodioden-Struktur 362 angeordnet.

Die Diamantschicht 358 wurde hier mittels CVD hergestellt und darin wurden Stickstofffehlstellenzentren durch Implantation von Dotanden (beispielsweise Schwefel) und anschließenden niederenergetischen Beschuss (1 eV bis 20 MeV) mit Fremdatomen (beispielsweise Stickstoff) erzeugt. Es wird bezüglich der Herstellung solcher Diamantschichten mit Stickstofffehlstellenzentren auf die PCT/EP2020/068110 verwiesen, deren diesbezügliche Offenbarungsgehalt vollumfänglich eingeschlossen wird.

Auch bei dieser Vorrichtung 200 findet eine Wellenlängenkonversion statt, allerdings wird hier durch die räumliche Entfernung von Diamantschicht 358 und Phosphormaterial 356 nur ein geringer Anteil an Förster-Transfer zu erwarten sein, so dass die Anregung der Stickstofffehlstellenzentren in der Diamantschicht 358 überwiegend strahlend erfolgen wird.

Aus der vorstehenden Darstellung ist deutlich geworden, dass mit der vorliegenden Erfindung eine Vorrichtung 10, 50, 100, 150, 200, 250, 300, 350 und ein Verfahren zur Bestimmung der magnetischen Flussdichte bereitgestellt werden, die eine einfache und kostengünstige Sensorik ermöglichen, die dennoch eine gute Nutzbarkeit aufweist. Insbesondere ist ein entsprechend hergestellter Sensor auch sehr klein und mobil verwendbar.

### Bezugszeichenliste

- 10: erste bevorzugte Ausgestaltung der erfindungsgemäßen Vorrichtung
- 12: Substrat
- 14: LED-Struktur
- 16: Matrix-Schicht
- 18: Diamantkörner
- 20: Konversionsmittel
- 22: Bragg-Spiegels
- 24: Photodioden-Struktur
- 50: zweite bevorzugte Ausgestaltung der erfindungsgemäßen Vorrichtung
- 52: Substrat
- 54: Photodioden-Struktur
- 56: Matrix-Schicht
- 58: Bragg-Spiegel
- 60: LED-Struktur
- 100: dritte bevorzugte Ausgestaltung der erfindungsgemäßen Vorrichtung
- 102: Substrat
- 104: Photodioden-Struktur
- 106: Bragg-Spiegel
- 108: LED-Struktur
- 110: Matrix-Schicht
- 150: vierte bevorzugte Ausgestaltung der erfindungsgemäßen Vorrichtung
- 152: Substrat
- 154: Matrix-Schicht
- 156: LED-Struktur
- 158: Bragg-Spiegel
- 160: Photodioden-Struktur
- 200: fünfte bevorzugte Ausgestaltung der erfindungsgemäßen Vorrichtung
- 202: Substrat
- 204: LED-Struktur
- 206: Schicht mit grünem Phosphormaterial
- 208: Schicht mit Diamantkörnern 18
- 210: Bragg-Spiegel
- 212: Photodioden-Struktur
- 250: sechste bevorzugte Ausgestaltung der erfindungsgemäßen Vorrichtung
- 252: Substrat
- 254: LED-Struktur
- 256: Matrix-Schicht
- 258: Halbleiter-Nanokristalle
- 260: Bragg-Spiegel
- 262: Photodioden-Struktur
- 300: siebente bevorzugte Ausgestaltung der erfindungsgemäßen Vorrichtung
- 302: Substrat
- 304: LED-Struktur
- 306: Matrix-Schicht
- 308: Quantenpunkte
- 310: Bragg-Spiegel
- 312: Photodioden-Struktur
- 350: achte bevorzugte Ausgestaltung der erfindungsgemäßen Vorrichtung
- 352: Substrat 352
- 354: LED-Struktur
- 356: Konversionsmaterial, Schicht mit grünem Phosphormaterial
- 358: Diamantschicht mit Stickstofffehlstellenzentren
- 360: Bragg-Spiegel
- 362: Photodioden-Struktur

## Patentansprüche

1. Vorrichtung (10; 50; 100; 150; 200; 250; 300; 350) zur Bestimmung der magnetischen Flussdichte mit
einem ersten Material (18; 358), das bei einer physikalischen Anregung eine Lumineszenz und/oder einen Photostrom erzeugt, wobei die Luminszenz bzw. der Photostrom von der magnetischen Flussdichte abhängig ist,
Mitteln (14, 20; 60, 20; 108, 20; 156, 20; 204, 20; 254, 20; 304, 308; 354; 358) zur Erzeugung der physikalischen Anregung und
Mitteln (24; 54; 104; 150; 212; 262; 312; 362) zur Messung der Lumineszenz bzw. des Photostroms mit einem Erfassungssignal, das die Stärke des erfassten Lumineszenzsignals bzw. Photostromsignals wiedergibt,
wobei das erste Material (18; 358) und die Mittel (14, 20; 60, 20; 108, 20; 156, 20; 204, 20; 254, 20; 304, 308; 354; 358) zur Erzeugung der physikalischen Anregung einstückig ausgebildet sind und/oder das erste Material (18; 358) und die Mittel (24; 54; 104; 160; 212; 262; 312; 362) zur Messung der Lumineszenz bzw. des Photostroms einstückig ausgebildet sind, **dadurch gekennzeichnet, dass** die Mittel (14, 20; 60, 20; 108, 20; 156, 20; 204, 20; 254, 20; 304, 308; 354; 358) zur Erzeugung der physikalischen Anregung eine Quelle (14; 60; 108; 156; 204; 254; 304; 354) und Konversionsmittel (20; 308; 356) aufweisen, wobei die Quelle (14; 60; 108; 156; 204; 254; 304; 354) eine erste physikalische Anregung im Lichtspektrum 200 nm bis 500 nm erzeugt und die Konversionsmittel (20; 308; 356) die erste physikalische Anregung in eine zweite physikalische Anregung im Lichtspektrum 500 nm bis 600 nm umwandeln.

2. Vorrichtung (10; 50; 100; 150; 200; 250; 300; 350) nach Anspruch 1, **dadurch gekennzeichnet,**
**dass** das erste Material (18; 358) und die Mittel (14, 20; 60, 20; 108, 20; 156, 20; 204, 20; 254, 20; 304, 308; 354; 358) zur Erzeugung der physikalischen Anregung und/oder das erste Material (18; 358) und die Mittel (24; 54; 104; 160; 212; 262; 312; 362) zur Messung der Lumineszenz bzw. des Photostroms als Schichten eines Schichtstapels vorliegen.

3. Vorrichtung (10; 50; 100; 150; 200; 250; 300; 350) nach Anspruch 1 oder 2, **dadurch gekennzeichnet, dass** zwischen den Mitteln (14, 20; 60, 20; 108, 20; 156, 20; 204, 20; 254, 20; 304, 308; 354; 358) zur Erzeugung der physikalischen Anregung und den Mitteln (24; 54; 104; 160; 212; 262; 312; 362) zur Messung der Lumineszenz bzw. des Photostroms Mittel (22; 58; 106; 158; 210; 250; 310; 360) zur Dämpfung der physikalischen Anregung angeordnet sind, wobei die Mittel zur Dämpfung bevorzugt als dielektrischer Spiegel, insbesondere als Bragg-Spiegel (22; 58; 106; 158; 210; 260; 310; 360), ausgebildet sind.

4. Vorrichtung (10; 50; 100; 150; 200; 250; 300; 350) nach einem der vorherigen Ansprüche, **dadurch gekennzeichnet, dass** das erste Material eine Kristallstruktur aufweist mit zumindest einer Fehlstelle, wobei das erste Material bevorzugt Diamant (18; 358), Siliziumkarbid oder Silizium ist und die Fehlstelle ein Farbzentrum, insbesondere ein Stickstofffehlstellenzentrum oder ein Stickstofffehlstellenzentrum in Verbindung mit einem Europiumfehlstellenzentrum, einem Vanadiumfehlstellenzentrum oder einem Manganfehlstellenzentrum ist.

5. Vorrichtung (10; 50; 100; 150; 200; 250; 300; 350) nach einem der vorherigen Ansprüche, **dadurch gekennzeichnet, dass** die Mittel (14, 20; 60, 20; 108, 20; 156, 20; 204, 20; 254, 20; 304, 308; 354; 358) zur Erzeugung der physikalischen Anregung eine Anregung im optischen Bereich, insbesondere eine LASER-Anregung oder eine LED-Anregung bereitstellen.

6. Vorrichtung (10; 50; 100; 150; 200; 250; 300; 350) nach einem der vorherigen Ansprüche, **dadurch gekennzeichnet,**
**dass** die Mittel (14, 20; 60, 20; 108, 20; 156, 20; 204, 20; 254, 20; 304, 308; 354; 358) zur Erzeugung der physikalischen Anregung ein zweites Material aus der Gruppe: AIN, AlGaN, AIGalnN, C, BN, GaN, GaP, GaAsP, AlGaInP, AIGaP, InGaN, ZnO; ZnSe, SiC und Si umfassen und/oder
**dass** die Konversionsmittel (20; 308; 356) ein drittes Material aus der Gruppe: Phosphormaterial, metallische Nanocluster, seltene Erden, CdS, CdSe, CdTe, GaAs und InP umfassen und/oder
**dass** zumindest Teile der Mittel (14, 20; 60, 20; 108, 20; 156, 20; 204, 20; 254, 20; 304, 308) zur Erzeugung der physikalischen Anregung, bevorzugt die Konversionsmittel (20; 308; 356), in einer Matrix (16; 56; 110; 154; 256; 306) mit dem ersten Material (18), insbesondere im Rahmen einer gemeinsamen Schicht (16; 56; 110; 154; 256; 306), vorliegen.

7. Vorrichtung (10; 50; 100; 150; 200; 250; 300; 350) nach einem der vorherigen Ansprüche, **dadurch gekennzeichnet,**
**dass** das erste Material (18) Körner aufweist, die vorzugsweise eine Korngröße im Bereich 100 nm bis 10 µm, bevorzugt im Bereich 200 nm bis 3 µm, insbesondere im Bereich 500 nm bis 1 µm aufweisen und/oder
**dass** die Mittel (24; 54; 104; 160; 212; 262; 312; 362) zur Messung der Lumineszenz einen Photodetektor umfassen.

8. Vorrichtung nach einem der vorherigen Ansprüche, **dadurch gekennzeichnet, dass** die Vorrichtung Mittel zur Erzeugung einer magnetischen Flussdichte aufweist,
wobei die Mittel zur Erzeugung einer magnetischen Flussdichte angepasst sind, eine magnetische Flussdichte von zumindest 5 mT, bevorzugt zumindest 7 mT, insbesondere von zumindest 10 mT zu erzeugen, und/oder
wobei die Mittel zur Erzeugung einer magnetischen Flussdichte angepasst sind, so geregelt zu werden, dass sich eine bestimmte Lumineszenz einstellt.

9. Verfahren zur Herstellung einer Vorrichtung (10; 50; 100; 150; 200; 250; 300; 350) zur Bestimmung der magnetischen Flussdichte, wobei die Vorrichtung (10; 50; 100; 150; 200; 250; 300; 350) ein erstes Material (18; 358), das bei einer physikalischen Anregung eine Lumineszenz und/oder einen Photostrom erzeugt, wobei die Luminszenz bzw. der Photostrom von der magnetischen Flussdichte abhängig ist,
Mittel (14, 20; 60, 20; 108, 20; 156, 20; 204, 20; 254, 20; 304, 308; 354; 358) zur Erzeugung der physikalischen Anregung und
Mittel (24; 54; 104; 160; 212; 262; 312; 362) zur Messung der Lumineszenz bzw. des Photostroms mit einem Erfassungssignal, das die Stärke des erfassten Lumineszenzsignals bzw. Photostromsignals wiedergibt, aufweist,
wobei das erste Material (18; 358) und die Mittel (14, 20; 60, 20; 108, 20; 156, 20; 204, 20; 254, 20; 304, 308; 354; 358) zur Erzeugung der physikalischen Anregung einstückig ausgebildet werden und/oder das erste Material (18; 358) und die Mittel (24; 54; 104; 160; 212; 262; 312; 362) zur Messung der Lumineszenz bzw. des Photostroms einstückig ausgebildet werden,
**dadurch gekennzeichnet, dass** die Mittel (14, 20; 60, 20; 108, 20; 156, 20; 204, 20; 254, 20; 304, 308; 354; 358) zur Erzeugung der physikalischen Anregung eine Quelle (14; 60; 108; 156; 204; 254; 304; 354) und Konversionsmittel (20; 308; 356) aufweisen, wobei die Quelle (14; 60; 108; 156; 204; 254; 304; 354) eine erste physikalische Anregung im Lichtspektrum 200 nm bis 500 nm erzeugt und die Konversionsmittel (20; 308; 356) die erste physikalische Anregung in eine zweite physikalische Anregung im Lichtspektrum 500 nm bis 600 nm umwandeln.

10. Verfahren nach Anspruch 9, **dadurch gekennzeichnet, dass** die Vorrichtung (10; 50; 100; 150; 200; 250; 300; 350) nach einem der Ansprüche 2 bis 9 hergestellt wird.

11. Verfahren nach Anspruch 9 oder 10, **dadurch gekennzeichnet, dass** eine LED-Struktur (14; 60; 108; 156; 204; 254; 304; 354) als besagte Quelle erzeugt und darauf das erste Material (18; 358) angeordnet, bevorzugt abgeschieden wird, wobei das erste Material (18) insbesondere in einer Matrix (16; 56; 110; 154; 256; 306) mit den Konversionsmitteln (20; 308) angeordnet wird.

12. Verfahren nach Anspruch 112, **dadurch gekennzeichnet, dass** das erste Material (18) und ggf. die Konversionsmittel (20; 308) im Sol-Gel-Verfahren abgeschieden werden.

13. Verfahren nach Anspruch 11 oder 12, **dadurch gekennzeichnet,**
**dass** die Mittel (22; 58; 210; 260; 310; 360) zur Dämpfung gegenüberliegend von der LED-Struktur (14; 60; 204; 254; 304; 354) auf dem ersten Material (18; 358) und darauf die Mittel (24; 54; 212; 262; 312; 362) zur Messung der Lumineszenz bzw. des Photostroms angeordnet werden, wobei die LED-Struktur (14; 60; 204; 254; 304; 354), das erste Material (18; 358), die Mittel (22; 58; 210; 250; 310; 360) zur Dämpfung und die Mittel (24; 54; 212; 262; 312; 362) zur Messung der Lumineszenz bzw. des Photostroms bevorzugt direkt aufeinander angeordnet werden, oder
**dass** die Mittel (106; 158) zur Dämpfung gegenüberliegend von dem ersten Material (18) auf der LED-Struktur (108; 156) und darauf die Mittel (104; 160) zur Messung der Lumineszenz bzw. des Photostroms angeordnet werden, wobei die Mittel (104; 160) zur Messung der Lumineszenz bzw. des Photostroms, die Mittel (106; 158) zur Dämpfung, die LED-Struktur (108; 156) und das erste Material (18) bevorzugt direkt aufeinander angeordnet werden.

14. Verfahren zur Bestimmung einer magnetischen Flussdichte mit einer Vorrichtung (10; 50; 100; 150; 200; 250; 300; 350) nach einem der Ansprüche 1 bis 8, **dadurch gekennzeichnet, dass** aus dem Wert der gemessenen Intensität der Luminszenz bzw. des Photostroms gegenüber einem normierten Verlauf der Intensität der Luminszenz bzw. des Photostroms in Bezug auf die magnetische Flussdichte die Größe der aktuellen magnetischen Flussdichte bestimmt wird, wobei bevorzugt keine Mikrowellenanregung erfolgt.

## Claims

1. Device (10; 50; 100; 150; 200; 250; 300; 350) for determining the magnetic flux density with
a first material (18; 358) which generates a luminescence and/or a photocurrent on physical excitation, the luminescence or the photocurrent being dependent on the magnetic flux density,
means (14, 20; 60, 20; 108, 20; 156, 20; 204, 20; 254, 20; 304, 308; 354; 358) for generating the physical excitation and
means (24; 54; 104; 160; 212; 262; 312; 362) for measuring the luminescence or the photocurrent with a detection signal which represents the strength of the detected luminescence signal or photocurrent signal,
wherein the first material (18; 358) and the means (14, 20; 60, 20; 108, 20; 156, 20; 204, 20; 254, 20; 304, 308; 354; 358) for generating the physical excitation are formed in one piece and/or the first material (18; 358) and the means (24; 54; 104; 160; 212; 262; 312; 362) for measuring the luminescence or the photocurrent are formed in one piece, **characterized in that** the means (14, 20; 60, 20; 108, 20; 156, 20; 204, 20; 254, 20; 304, 308; 354; 358) for generating the physical excitation are formed in one piece. of the photocurrent are formed in one piece, **characterized in that** the means (14, 20; 60, 20; 108, 20; 156, 20; 204, 20; 254, 20; 304, 308; 354; 358) for generating the physical excitation comprise a source (14; 60; 108; 156; 204; 254; 304; 354) and conversion means (20; 308; 356), the source (14; 60; 108; 156; 204; 254; 304; 354) generating a first physical excitation in the light spectrum 200 nm to 500 nm and the conversion means (20; 308; 356) converting the first physical excitation into a second physical excitation in the light spectrum 500 nm to 600 nm.

2. device (10; 50; 100; 150; 200; 250; 300; 350) according to claim 1, **characterized in that**,
**in that** the first material (18; 358) and the means (14, 20; 60, 20; 108, 20; 156, 20; 204, 20; 254, 20; 304, 308; 354; 358) for generating the physical excitation and/or the first material (18; 358) and the means (24; 54; 104; 160; 212; 262; 312; 362) for measuring the luminescence or the photocurrent are present as layers of a layer stack.

3. device (10; 50; 100; 150; 200; 250; 300; 350) according to claim 1 or 2, **characterized in that** means (22; 58; 106; 158; 210; 260; 310; 360) for attenuating the physical excitation are arranged between the means (14, 20; 60, 20; 108, 20; 156, 20; 204, 20; 254, 20; 304, 308; 354; 358) for generating the physical excitation and the means (24; 54; 104; 160; 212; 262; 312; 362) for measuring the luminescence or the photocurrent, wherein the means for attenuation are preferably designed as dielectric mirrors, in particular as Bragg mirrors (22; 58; 106; 158; 210; 260; 310; 360).

4. device (10; 50; 100; 150; 200; 250; 300; 350) according to one of the preceding claims, **characterized in that** the first material has a crystal structure with at least one defect, the first material preferably being diamond (18; 358), silicon carbide or silicon and the defect being a colour center, in particular a nitrogen vacancy center or a nitrogen vacancy center in conjunction with a europium vacancy center, a vanadium vacancy center or a manganese vacancy center.

5. device (10; 50; 100; 150; 200; 250; 300; 350) according to one of the preceding claims, **characterized in that** the means (14, 20; 60, 20; 108, 20; 156, 20; 204, 20; 254, 20; 304, 308; 354; 358) for generating the physical excitation provide an excitation in the optical range, in particular a LASER excitation or an LED excitation.

6. device (10; 50; 100; 150; 200; 250; 300; 350) according to one of the preceding claims, **characterized in that**,
**in that** the means (14, 20; 60, 20; 108, 20; 156, 20; 204, 20; 254, 20; 304, 308; 354; 358) for generating the physical excitation comprise a second material from the group: AIN, AlGaN, AlGaInN, C, BN, GaN, GaP, GaAsP, AlGaInP, AlGaP, InGaN, ZnO; ZnSe, SiC and Si and/or that the conversion means (20; 308; 356) comprise a third material from the group: phosphorus material, metallic nanoclusters, rare earths, CdS, CdSe, CdTe, GaAs and InP and/or in that at least parts of the means (14, 20; 60, 20; 108, 20; 156, 20; 204, 20; 254, 20; 304, 308) for generating the physical excitation, preferably the conversion means (20; 308; 356), are present in a matrix (16; 56; 110; 154; 256; 306) with the first material (18), in particular as part of a common layer (16; 56; 110; 154; 256; 306).

7. Device (10; 50; 100; 150; 200; 250; 300; 350) according to one of the preceding claims, **characterized in that**,
**in that** the first material (18) has grains which preferably have a grain size in the range from 100 nm to 10 µm, preferably in the range from 200 nm to 3 µm, in particular in the range from 500 nm to 1 µm, and/or
**in that** the means (24; 54; 104; 160; 212; 262; 312; 362) for measuring the luminescence comprise a photodetector.

8. Device according to one of the preceding claims, **characterized in that** the device comprises means for generating a magnetic flux density,
wherein the means for generating a magnetic flux density are adapted to generate a magnetic flux density of at least 5 mT, preferably at least 7 mT, in particular at least 10 mT, and/or
whereby the means for generating a magnetic flux density are adapted to be controlled in such a way that a certain luminescence is achieved.

9. method for producing a device (10; 50; 100; 150; 200; 250; 300; 350) for determining the magnetic flux density, the device (10; 50; 100; 150; 200; 250; 300; 350) comprising a first material (18; 358) which generates a luminescence and/or a photocurrent upon physical excitation, the luminescence or the photocurrent being dependent on the magnetic flux density,
means (14, 20; 60, 20; 108, 20; 156, 20; 204, 20; 254, 20; 304, 308; 354; 358) for generating the physical excitation and
means (24; 54; 104; 160; 212; 262; 312; 362) for measuring the luminescence or photocurrent with a detection signal representing the strength of the detected luminescence signal or photocurrent signal,
wherein the first material (18; 358) and the means (14, 20; 60, 20; 108, 20; 156, 20; 204, 20; 254, 20; 304, 308; 354; 358) for generating the physical excitation are formed in one piece and/or the first material (18; 358) and the means (24; 54; 104; 160; 212; 262; 312; 362) for measuring the luminescence or the photocurrent are formed in one piece,
**characterized in that** the means (14, 20; 60, 20; 108, 20; 156, 20; 204, 20; 254, 20; 304, 308; 354; 358) for generating the physical excitation comprise a source (14; 60; 108; 156; 204; 254; 304; 354) and conversion means (20; 308; 356), the source (14; 60; 108; 156; 204; 254; 304; 354) generating a first physical excitation in the light spectrum 200 nm to 500 nm and the conversion means (20; 308; 356) generating the first physical excitation in the light spectrum 200 nm to 500 nm; 60; 108; 156; 204; 254; 304; 354) generating a first physical excitation in the light spectrum 200 nm to 500 nm and the conversion means (20; 308; 356) converting the first physical excitation into a second physical excitation in the light spectrum 500 nm to 600 nm.

10. method according to claim 9, **characterized in that** the device (10; 50; 100; 150; 200; 250; 300; 350) is manufactured according to one of claims 2 to 9.

11. Method according to claim 9 or 10, **characterized in that** an LED structure (14; 60; 108; 156; 204; 254; 304; 354) is produced as said source and the first material (18; 358) is arranged, preferably deposited, thereon, the first material (18) being arranged in particular in a matrix (16; 56; 110; 154; 256; 306) with the conversion means (20; 308).

12. Method according to claim 112, **characterized in that** the first material (18) and optionally the conversion means (20; 308) are deposited in a sol-gel process.

13. Method according to claim 11 or 12, **characterized in that**,
**in that** the means (22; 58; 210; 260; 310; 360) for attenuation are arranged opposite the LED structure (14; 60; 204; 254; 304; 354) on the first material (18; 358) and on it the means (24; 54; 212; 262; 312; 362) for measuring the luminescence or of the photocurrent, wherein the LED structure (14; 60; 204; 254; 304; 354), the first material (18; 358), the means (22; 58; 210; 260; 310; 360) for attenuation and the means (24; 54; 212; 262; 312; 362) for measuring the luminescence or the photocurrent are preferably arranged directly on top of one another, or
**in that** the means (106; 158) for attenuation are arranged opposite the first material (18) on the LED structure (108; 156) and the means (104; 160) for measuring the luminescence or the photocurrent are arranged thereon, the means (104; 160) for measuring the luminescence or the photocurrent, the means (106; 158) for attenuation, the LED structure (108; 156) and the first material (18) preferably being arranged directly on top of one another.

14. method for determining a magnetic flux density with a device (10; 50; 100; 150; 200; 250; 300; 350) according to one of claims 1 to 8, **characterized in that** the magnitude of the current magnetic flux density is determined from the value of the measured intensity of the luminescence or of the photocurrent with respect to a normalized curve of the intensity of the luminescence or of the photocurrent with respect to the magnetic flux density, preferably without microwave excitation.

## Revendications

1. Dispositif (10 ; 50 ; 100 ; 150 ; 200 ; 250 ; 300 ; 350) pour la détermination de la densité du flux magnétique avec
un premier matériau (18 ; 358) qui génère une luminescence et/ou un photo-courant lors d'une excitation physique, la luminescence ou le photo-courant dépendant de la densité du flux magnétique, des moyens (14, 20 ; 60, 20 ; 108, 20 ; 156, 20 ; 204, 20 ; 254, 20 ; 304, 308 ; 354 ; 358) pour générer l'excitation physique et des moyens (24 ; 54 ; 104 ; 160 ; 212 ; 262 ; 312 ; 362) pour mesurer la luminescence ou le photo-courant avec un signal de détection qui représente l'intensité du signal de luminescence ou du signal de photo-courant détecté,
dans lequel le premier matériau (18 ; 358) et les moyens (14, 20 ; 60, 20 ; 108, 20 ; 156, 20 ; 204, 20 ; 254, 20 ; 304, 308 ; 354 ; 358) pour générer l'excitation physique sont formés en une seule pièce et/ou le premier matériau (18 ; 358) et les moyens (24 ; 54 ; 104 ; 160 ; 212 ; 262 ; 312 ; 362) pour mesurer la luminescence ou le photo-courant sont formés d'une seule pièce, **caractérisé en ce que** les moyens (14, 20 ; 60, 20 ; 108, 20 ; 156, 20 ; 204, 20 ; 254, 20 ; 304, 308 ; 354 ; 358) pour produire l'excitation physique une source (14 ; 60 ; 108 ; 156 ; 204 ; 254 ; 304 ; 354) et des moyens de conversion (20 ; 308 ; 356), la source (14 ; 60 ; 108 ; 156 ; 204 ; 254 ; 304 ; 354) produisant une première excitation physique dans le spectre lumineux de 200 nm à 500 nm, et les moyens de conversion (20 ; 308 ; 356) convertissent la première excitation physique en une deuxième excitation physique dans le spectre lumineux de 500 nm à 600 nm.

2. dispositif (10 ; 50 ; 100 ; 150 ; 200 ; 250 ; 300 ; 350) selon la revendication 1,
**caractérisé en ce que** le premier matériau (18 ; 358) et les moyens (14, 20 ; 60, 20 ; 108, 20 ; 156, 20 ; 204, 20 ; 254, 20 ; 304, 308 ; 354 ; 358) pour générer l'excitation physique et/ou le premier matériau (18 ; 358) et les moyens (24 ; 54 ; 104 ; 160 ; 212 ; 262 ; 312 ; 362) pour mesurer la luminescence ou le courant photoélectrique se présentent sous forme de couches d'un empilement de couches.

3. Dispositif (10 ; 50 ; 100 ; 150 ; 200 ; 250 ; 300 ; 350) selon la revendication 1 ou 2,
**caractérisé en ce que** qu'entre les moyens (14, 20 ; 60, 20 ; 108, 20 ; 156, 20 ; 204, 20 ; 254, 20 ; 304, 308 ; 354 ; 358) de génération de l'excitation physique et les moyens (24 ; 54 ; 104 ; 160 ; 212 ; 262 ; 312 ; 362) de mesure de la luminescence ou du photo-courant des moyens (22 ; 58 ; 106 ; 158 ; 210 ; 260 ; 310 ; 360) d'amortissement de l'excitation physique sont disposés, les moyens d'amortissement étant de préférence conçus comme des miroirs diélectriques, en particulier comme des miroirs de Bragg (22 ; 58 ; 106 ; 158 ; 210 ; 260 ; 310 ; 360).

4. dispositif (10 ; 50 ; 100 ; 150 ; 200 ; 250 ; 300 ; 350) selon l'une des revendications précédentes, **caractérisé en ce que** le premier matériau présente une structure cristalline avec au moins un défaut, le premier matériau étant de préférence du diamant (18 ; 358), du carbure de silicium ou du silicium et le défaut étant un centre coloré, en particulier un centre vacant d'azote ou un centre vacant d'azote en conjonction avec un centre vacant d'europium, un centre vacant de vanadium ou un centre vacant de manganèse.

5. dispositif (10 ; 50 ; 100 ; 150 ; 200 ; 250 ; 300 ; 350) selon l'une quelconque des revendications précédentes, **caractérisé en ce que** les moyens (14, 20 ; 60, 20 ; 108, 20 ; 156, 20 ; 204, 20 ; 254, 20 ; 304, 308 ; 354 ; 358) pour générer l'excitation physique fournissent une excitation dans le domaine optique, en particulier une excitation LASER ou une excitation LED.

6. dispositif (10 ; 50 ; 100 ; 150 ; 200 ; 250 ; 300 ; 350) selon l'une des revendications précédentes, **caractérisé en ce que**
**en ce que** les moyens (14, 20 ; 60, 20 ; 108, 20 ; 156, 20 ; 204, 20 ; 254, 20 ; 304, 308 ; 354 ; 358) de production de l'excitation physique comprennent un deuxième matériau choisi dans le groupe : AIN, AIGaN, AIGalnN, C, BN, GaN, GaP, GaAsP, AIGalnP, AlGaP, InGaN, ZnO ; ZnSe, SiC et Si et/ou
les moyens de conversion (20 ; 308 ; 356) comprennent un troisième matériau du groupe : matériau phosphoré, nano-clusters métalliques, terres rares, CdS, CdSe, CdTe, GaAs et InP et/ou
**en ce qu'**au moins des parties des moyens (14, 20 ; 60, 20 ; 108, 20 ; 156, 20 ; 204, 20 ; 254, 20 ; 304, 308) de production de l'excitation physique, de préférence les moyens de conversion (20 ; 308 ; 356), sont présents dans une matrice (16 ; 56 ; 110 ; 154 ; 256 ; 306) avec le premier matériau (18), notamment dans le cadre d'une couche commune (16 ; 56 ; 110 ; 154 ; 256 ; 306).

7. Dispositif (10 ; 50 ; 100 ; 150 ; 200 ; 250 ; 300 ; 350) selon l'une des revendications précédentes, **caractérisé en ce que** le premier matériau (18) présente des grains qui présentent de préférence une granulométrie de l'ordre de 100 nm à 10 µm, de préférence de l'ordre de 200 nm à 3 µm, en particulier de l'ordre de 500 nm à 1 µm et/ou en ce que les moyens (24 ; 54 ; 104 ; 160 ; 212 ; 262 ; 312 ; 362) de mesure de la luminescence comprennent un photodétecteur.

8. Dispositif selon l'une quelconque des revendications précédentes, **caractérisé en ce que** le dispositif comprend des moyens pour générer une densité de flux magnétique, les moyens de génération d'une densité de flux magnétique étant adaptés, à générer une densité de flux magnétique d'au moins 5 mT, de préférence d'au moins 7 mT, en particulier d'au moins 10 mT, et/ou les moyens de génération d'une densité de flux magnétique étant adaptés, être régulés de manière à , de sorte qu'une certaine luminescence s'installe.

9. procédé de fabrication d'un dispositif (10 ; 50 ; 100 ; 150 ; 200 ; 250 ; 300 ; 350) pour déterminer la densité de flux magnétique, le dispositif (10 ; 50 ; 100 ; 150 ; 200 ; 250 ; 300 ; 350) comprenant un premier matériau (18 ; 358) qui, lorsqu'il est excité physiquement, produit une luminescence et/ou un photo-courant, la luminescence ou le photo-courant dépendant de la densité de flux magnétique, des moyens (14, 20 ; 60, 20 ; 108, 20 ; 156, 20 ; 204, 20 ; 254, 20 ; 304, 308 ; 354 ; 358) pour produire l'excitation physique et des moyens (24 ; 54 ; 104 ; 160 ; 212 ; 262 ; 312 ; 362) pour mesurer la luminescence ou le photo-courant avec un signal de détection qui reflète l'intensité du signal de luminescence ou du photo-courant détecté, le premier matériau (18 ; 358) et les moyens (14, 20 ; 60, 20 ; 108, 20 ; 156, 20 ; 204, 20 ; 254, 20 ; 304, 308 ; 354 ; 358) pour générer l'excitation physique étant formés d'une seule pièce et/ou le premier matériau (18 ; 358) et les moyens (24 ; 54 ; 104 ; 160 ; 212 ; 262 ; 312 ; 362) pour mesurer la luminescence ou le photo-courant sont formés d'une seule pièce, **caractérisé en ce que** les moyens (14, 20 ; 60, 20 ; 108, 20 ; 156, 20 ; 204, 20 ; 254, 20 ; 304, 308 ; 354 ; 358) pour produire l'excitation physique comprennent une source (14 ; 60 ; 108 ; 156 ; 204 ; 254 ; 304 ; 354) et des moyens de conversion (20 ; 308 ; 356), la source (14 ; 60 ; 108 ; 156 ; 204 ; 254 ; 304 ; 354) produisant une première excitation physique dans le spectre lumineux de 200 nm à 500 nm, et
les moyens de conversion (20 ; 308 ; 356) convertissent la première excitation physique en une deuxième excitation physique dans le spectre lumineux de 500 nm à 600 nm.

10. Procédé selon la revendication 9, **caractérisé par le fait que** le dispositif (10 ; 50 ; 100 ; 150 ; 200 ; 250 ; 300 ; 350) est fabriqué selon l'une des revendications 2 à 9.

11. procédé selon la revendication 9 ou 10, **caractérisé en ce qu'**une structure LED (14 ; 60 ; 108 ; 156 ; 204 ; 254 ; 304 ; 354) est générée comme ladite source et le premier matériau (18 ; 358) est disposé, de préférence déposé, sur celle-ci, le premier matériau (18) étant notamment disposé dans une matrice (16 ; 56 ; 110 ; 154 ; 256 ; 306) avec les moyens de conversion (20 ; 308).

12. Procédé selon la revendication 112, **caractérisé par le fait que** le premier matériau (18) et éventuellement les moyens de conversion (20 ; 308) sont déposés par un procédé sol-gel.

13. procédé selon la revendication 11 ou 12, **caractérisé en ce que** les moyens (22 ; 58 ; 210 ; 260 ; 310 ; 360) d'atténuation sont disposés en regard de la structure de LED (14 ; 60 ; 204 ; 254 ; 304 ; 354) sur le premier matériau (18 ; 358) et, sur celui-ci, les moyens (24 ; 54 ; 212 ; 262 ; 312 ; 362) de mesure de la luminescence ou du photo-courant, la structure LED (14 ; 60 ; 204 ; 254 ; 304 ; 354), le premier matériau (18 ; 358), les moyens (22 ; 58 ; 210 ; 260 ; 310 ; 360) d'atténuation et les moyens (24 ; 54 ; 212 ; 262 ; 312 ; 362) de mesure de la luminescence ou du photo-courant étant de préférence disposés directement les uns sur les autres, ou **en ce que** les moyens (106 ; 158) pour l'atténuation sont disposés en face du premier matériau (18) sur la structure LED (108 ; 156) et, sur celle-ci, les moyens (104 ; 160) pour la mesure de la luminescence ou du photo-courant, les moyens (104 ; 160) de mesure de la luminescence ou du photo-courant, les moyens (106 ; 158) d'atténuation, la structure LED (108 ; 156) et le premier matériau (18) étant de préférence disposés directement les uns sur les autres.

14. Procédé de détermination d'une densité de flux magnétique avec un dispositif (10 ; 50 ; 100 ; 150 ; 200 ; 250 ; 300 ; 350) selon l'une des revendications 1 à 8, **caractérisé en ce que** l'on détermine la valeur de la densité de flux magnétique actuelle à partir de la valeur de l'intensité mesurée de la luminescence ou du photo-courant par rapport à une courbe normalisée de l'intensité de la luminescence ou du photo-courant par rapport à la densité de flux magnétique, de préférence sans excitation de micro-ondes.
